# EUROPÄISCHE PATENTSCHRIFT

(11) **EP 3 524 040 B1**
(45) Veröffentlichungstag und Bekanntmachung des Hinweises auf die Patenterteilung: **15.12.2021**
(21) Anmeldenummer: 17764551.2
(22) Anmeldetag: 05.09.2017
(51) Int. Cl.: H05K 1/16, H05K 1/02, H05K 1/05, H05K 5/00, H01F 41/04, H01F 17/00, H01F 5/00

(54) **VIBRATIONSFESTE SCHALTUNGSANORDNUNG ZUM ELEKTRISCHEN VERBINDEN ZWEIER ANSCHLUSSBEREICHE SOWIE KRAFTFAHRZEUG UND VERFAHREN ZUM HERSTELLEN DER SCHALTUNGSANORDNUNG**
VIBRATION-RESISTANT CIRCUIT ARRANGEMENT FOR ELECTRICALLY CONNECTING TWO TERMINAL REGIONS, MOTOR VEHICLE, AND METHOD FOR MANUFACTURING SAID CIRCUIT ARRANGEMENT
ENSEMBLE CIRCUIT RÉSISTANT AUX VIBRATIONS, POUR CONNECTER ÉLECTRIQUEMENT DEUX POINTS DE CONNEXION, AINSI QUE VÉHICULE AUTOMOBILE ET PROCÉDÉ DE FABRICATION DE CET ENSEMBLE CIRCUIT

(30) Priorität: 05.10.2016 DE 102016219309
(43) Veröffentlichungstag der Anmeldung: 14.08.2019
(73) Patentinhaber: Vitesco Technologies GmbH, 93055 Regensburg (DE)
(72) Erfinder: JASTER, Magnus, 14774 Kirchmöser (DE)
(86) Internationale Anmeldenummer: PCT/EP2017/072259
(87) Internationale Veröffentlichungsnummer: WO 2018/065160

(56) Entgegenhaltungen:
- EP-A1- 2 652 755
- DE-A1-102004 058 806
- DE-A1-102011 076 773
- DE-A1-102014 214 784
- US-A1- 2005 033 819
- US-A1- 2006 108 601
- US-A1- 2008 003 760
- US-A1- 2013 234 819

## Beschreibung

Die Erfindung betrifft eine Schaltungsanordnung, bei welcher zwei elektrische Anschlussbereiche über einen elektrischen Verbindungspfad miteinander verbunden sind. Dieser Verbindungspfad soll robust gegen vibrationsbedingten Bruch sein. Zu der Erfindung gehören auch ein Kraftfahrzeug mit der erfindungsgemäßen Schaltungsanordnung sowie ein Verfahren zum Herstellen der Schaltungsanordnung.

Eine Schaltungsanordnung, wie sie beispielsweise in einem Kraftfahrzeug bereitgestellt sein kann, muss gegen Vibrationen robust sein, damit ein elektrisches Leitelement sich bei Vibrationen nicht beispielsweise aus einer Lötverbindung löst oder in sich reißt oder bricht. Ein besonderes Problem können hierbei elektrische Spulen einer Leistungselektronik zum Betreiben einer elektrischen Maschine eines Kraftfahrzeugs darstellen, da solche Spulen eine verhältnismäßig große Induktivität aufweisen und einen hohen Dauerstrom führen müssen, was zu verhältnismäßig vielen Wicklungen und schweren Ferriten führt, so dass sie eine punktuelle Masse darstellen, die durch Vibrationen zum Schwingen oder Schaukeln angeregt werden kann. Zudem kann sich in einem solchen Bauelement bei großen Betriebsströmen ein Hitzestau (Hotspot) entwickeln.

Aus der DE 10 2011 076 773 A1 ist die Verwendung eines Kaltgas-Spritzverfahrens zum Herstellen von elektrischen Verbindungen in einer integrierten Schaltung (IC - Integrated Circuit) bekannt. Ferner offenbart DE 10 2011 076 773 A1 ein Verfahren zur Herstellung einer integrierten Schaltung mit einem Leistungsteil und einem Ansteuerteil auf einem Trägersubstrat, wobei der Ansteuerteil auf dem Trägersubstrat über einen Dickschichtprozess mit den erforderlichen Leiterbahnanbindungen für den Leistungsteil unter Freihaltung des Leistungsteiles ausgebildet wird.

Aus der US 2006/108601 A1 ist ein Verfahren zur Herstellung eines isolierenden Substrats mit einer Metallbasis bekannt, bei dem feine keramische Partikel aus Gemisch von Siliziumoxid, Aluminiumoxid sowie von Siliziumnitrid, Bornitrid und Aluminiumnitrid vermischt werden. Aus den entstehenden feinen keramischen Partikeln wird mittels eines Aerosolablagerungsverfahrens eine Isolierschicht schockverfestigt. Auf der Isolierschicht wird ein Schaltungsmuster ausgebildet.

Aus der DE 10 2004 058806 A1 ist ein Verfahren zur Herstellung von Schaltungsstrukturen auf einem Kühlkörper bekannt, bei dem direkt auf dem Kühlkörper additiv mindestens eine spezifisch strukturierte, elektrisch isolierende Schicht und mindestens eine spezifisch strukturierte, elektrisch leitende Schicht ausgebildet werden.

Aus der EP 2 652 755 A1 ist ein Dünnschichtinduktor bekannt, der mehrere Leiter und ein ferromagnetisches Joch aufweist, das teilweise um die Leiter gewickelt ist.

Aus der US 2008/003760 A1 ist eine magnetische Durchkontaktierung bekannt, welche die Induktivität eines integrierten Induktors oder Transformators erhöht, während darin Wirbelströme reduziert werden, die den Betrieb des Induktors oder Transformators bei hoher Frequenz einschränken können.

Aus der US 2013/234819 A1 ist ein Gleichtaktfilter bekannt, der ein erstes magnetisches Substrat, ein erstes Laminat auf dem ersten magnetischen Substrat, eine Primärspulenelektrode, eine magnetische Kernschicht auf dem ersten Laminat, ein zweites Laminat auf der magnetischen Kernschicht, eine Sekundärspulenelektrode, sowie ein zweites magnetisches Substrat auf dem zweiten Laminat aufweist.

Aus der US 2005/033819 A1 ist eine differenzielle drahtlose Erfassungsvorrichtung bekannt, die eine erste Resonanzvorrichtung aufweist, die auf ein Substrat mit einer vorbestimmten Eigenfrequenz einwirkt, und eine zweite Resonanzvorrichtung, die auf das Substrat mit einer vorbestimmten statischen Resonanzfrequenz einwirkt.

Aus der DE 10 2014 214784 A1 ist ein Schaltungsträger bekannt, der einen metallischen Kühlkörper, eine unmittelbar auf der Oberfläche des Kühlkörpers thermisch spritzbeschichtete keramische Isolationsschicht sowie eine unmittelbar auf der Oberfläche der Isolationsschicht thermisch spritzbeschichtete metallische Leiterbahnschicht aufweist, wobei die Leiterbahnschicht eine Leiterbahn des Schaltungsträgers zum Übertragen von elektrischem Strom ausbildet.

Der Erfindung liegt die Aufgabe zugrunde, eine vibrationsfeste, einfach kühlbare elektrische Verbindung zwischen zwei Anschlussbereichen bereitzustellen, die eine kurze Anbindung an Halbleiter zulässt.

Die Aufgabe wird durch die Gegenstände der unabhängigen Patentansprüche gelöst. Vorteilhafte Weiterbildungen der Erfindung sind durch die abhängigen Patentansprüche, die folgende Beschreibung sowie die Figuren beschrieben.

Die Erfindung stellt eine Schaltungsanordnung bereit, durch welche ein elektrischer Verbindungspfad oder Strompfad zwischen zwei elektrischen Anschlussbereichen bereitgestellt ist. Mit Anschlussbereich ist hierbei ein Kontaktbereich oder Übergangsbereich gemeint, über welchen die Schaltungsanordnung mit weiteren Schaltungselementen oder Schaltungsteilen elektrisch verbunden sein kann. Die Schaltungsanordnung weist einen Kühlkörper auf, an dessen Oberfläche eine Schichtanordnung bereitgestellt ist, um den Verbindungspfad bereitzustellen. Die Schichtanordnung ist durch Kaltgasspritzen eines jeweiligen Materials einer oder einiger oder jeder der Schichten der Schichtanordnung gebildet. Der Kühlkörper kann auch als Wärmeleitkörper zum Koppeln der Schichtanordnung mit einer anderen Komponente vorgesehen sein, um z.B. gezielt entweder die Schichtanordnung oder die andere Komponente zu erwärmen, z.B. im Winter.

Die Schichtanordnung weist dabei eine elektrisch isolierende Schicht auf, die hier als Isolierschicht (Isolationsschicht) bezeichnet ist. Der Kühlkörper kann aus einem Metall, zum Beispiel Aluminium oder einer Aluminiumlegierung, gebildet sein. Die Isolierschicht isoliert eine Leiterschicht bezüglich des Kühlkörpers. Diese Leiterschicht ist also auf einer dem Kühlkörper abgewandten Seite der Isolierschicht angeordnet und aus einem elektrisch leitfähigen Material gebildet. Elektrisch isolierend meint im Zusammenhang mit der Erfindung, dass eine elektrische Leitfähigkeit oder Konduktivität kleiner als 10-5 S/m, insbesondere kleiner als 10-6 S/m ist. Unter elektrisch leitfähig ist im Zusammenhang mit der Erfindung eine Leitfähigkeit oder Konduktivität größer als 10 000 S/m, insbesondere größer als 100 000 S/m zu verstehen.

Der besagte elektrische Verbindungspfad ist also durch die Schichtanordnung flächig oder durch eine Laminierung oder Beschichtung auf einem Kühlkörper gebildet. Hierdurch ist der Verbindungspfad oder die Leiterschicht durch den Kühlkörper versteift oder gestützt, sodass die Schichtanordnung bei einer Anregung durch Vibrationen keine Eigenschwingung ausführen kann. Des Weiteren ist durch die flächige Ausgestaltung als Schichtanordnung eine Abgabe von Wärmeleistung aus der Leiterschicht in den Kühlkörper begünstigt. Zum Bereitstellen der Leiterschicht kann als Material zum Beispiel Kupfer oder Aluminium oder eine Aluminiumlegierung vorgesehen sein. Die Isolierschicht kann zum Beispiel auf der Grundlage einer Keramik oder Aluminiumoxid gebildet sein.

Die Schaltungsanordnung weist ferner einen Hochstromverbraucher auf, der auf der Oberfläche des Kühlkörpers angeordnet ist. Der Kühlkörper weist an seiner Oberfläche und zwischen dem Hochstromverbraucher einerseits und der Schichtanordnung andererseits mindestens zwei Materialaussparungen zur thermischen Entkopplung auf.

Die Erfindung stellt auch ein Verfahren zum Herstellen der Schaltungsanordnung mittels Kaltgasspritzens bereit. Mit anderen Worten wird das Material der Isolierschicht und der Leiterschicht jeweils in Form von einem Granulat oder einem Pulver bereitgestellt und mittels des Kaltgasspritzens auf den Kühlkörper aufgetragen oder aufgebracht oder dort angeordnet. Das erfindungsgemäße Verfahren sieht somit vor, auf der Oberfläche des Kühlkörpers mittels Kaltgasspritzens die Schichtanordnung mit der Isolierschicht aus dem elektrisch isolierenden Material und die an der dem Kühlkörper abgewandten Seite der Isolierschicht angeordneten Leiterschicht aus dem elektrisch leitfähigen Material erzeugt. Durch die Schichtanordnung wird hierbei der elektrische Verbindungspfad zwischen den Anschlussbereichen bereitgestellt. Hierzu kann beispielsweise mittels einer Maske oder Schablone auf dem Kühlkörper festgelegt werden, wo das Material der Isolierschicht und das darauf angeordnete Material der Leiterschicht aufgetragen oder angeordnet wird. Die Leiterschicht ist dabei insbesondere mindestens 0,5 cm, insbesondere mindestens 1 cm breit und/oder der Verbindungspfad mindestens 2 cm lang. Es handelt sich also nicht um eine Mikrostruktur eines integrierten Schaltkreises auf einem Substrat. Die Dicke kann bis zu einigen µm dünn sein. Die Breite und/oder die Länge kann größer als 0.75 mm sein. Aber es ist dennoch kein integrierter Schaltkreis.

Zu der Erfindung gehören auch optionale Weiterbildungen, durch deren Merkmale sich zusätzliche Vorteile ergeben.

Wie bereits eingangs beschrieben, stellt insbesondere eine Induktivität ein kritisches Bauteil in Bezug auf die Anfälligkeit für Eigenschwingungen bei Vibrationen dar. Eine Weiterbildung der Erfindung sieht deshalb vor, dass zum Einstellen eines elektrischen Induktivitätswerts des Verbindungspfads die Schichtanordnung zwei weitere Schichten aufweist, die hier als Magnetschichten bezeichnet sind. Eine der Magnetschichten ist zwischen der Oberfläche des Kühlkörpers und der ersten Isolierschicht angeordnet. Diese Magnetschicht ist also an der Oberfläche des Kühlkörpers angeordnet und hält die Isolierschicht. Die zweite Magnetschicht ist zum Abdecken der Leiterschicht vorgesehen. Damit hierbei nicht ungewollt ein Strom durch die Magnetschicht fließt, ist zunächst eine an der von der ersten Isolierschicht abgewandten Seite der Leiterschicht eine zweite Isolierschicht aus einem elektrisch isolierenden Material auf der Leiterschicht angeordnet. Die zweite Magnetschicht ist dann bezüglich der Leiterschicht an der der ersten Magnetschicht gegenüber liegenden Seite angeordnet. Die erste Magnetschicht und die zweite Magnetschicht berühren einander aber an den Rändern, sodass Sie einen Schlauch oder eine geschlossene Hülle um die Leiterschicht und die beiden Isolierschichten bilden. Es kann alternativ auch gezielt ein Spalt vorgesehen sein, indem eine der Isolierschichten die beiden Magnetschichten trennt.

Somit ergibt sich im Querschnitt senkrecht zu einem Verlauf oder einer Längsrichtung des elektrischen Verbindungspfads ein geschlossener Magnetkreis aus weichmagnetischem Material. Mit anderen Worten ist die zweite Magnetschicht entlang eines Verlaufs des elektrischen Verbindungspfads beiderseits dieses Verbindungspfads mit der ersten Magnetschicht verbunden. Jede Magnetschicht ist aus einem weichmagnetischen Material gebildet, beispielsweise Eisen oder eine Eisenlegierung. Mit weichmagnetisch ist hierbei gemeint, dass das Material ferromagnetisch ist und eine Koerzitivfeldstärke mit einem Wert kleiner als 1000 A/m aufweist. Die beiden Magnetschichten bilden durch ihre Berührung entlang des Verbindungspfads somit eine weichmagnetische Hülle um die Leiterschicht, wodurch der Induktivitätswert der Leiterschicht vergrößert wird. Durch Wahl der Dicke der Magnetschichten und/oder durch Wahl des weichmagnetischen Materials kann der Induktivitätswert eingestellt werden.

Optional kann eine zusätzliche Isolierschicht zwischen dem Kühlkörper und der ersten Magnetschicht vorgesehen sein, um z.B. Wirbelströme zu blockieren.

Bspw. weist die Schaltungsanordnung zwischen jeweils zwei der Materialaussparungen ein Brückenelement auf, über welches die Schichtanordnung mit dem Hochstromverbraucher elektrisch verbunden ist.

Bevorzugt ist vorgesehen, dass das weichmagnetische Material der ersten Magnetschicht und der zweiten Magnetschicht porös ist. Eine poröse Struktur, in welcher also zwischen dem weichmagnetischen Material Luft angeordnet ist, ersetzt einen diskreten Luftspalt zum Einstellen des Induktivitätswerts.

Ein weiterer Parameter zum Einstellen des Induktivitätswerts ist die Länge des elektrischen Verbindungspfads. Um auf gegebener Fläche einen Verbindungspfad vorgegebener Länge einzustellen, kann vorgesehen sein, dass der Verbindungspfad meanderförmig oder als Flachspule, d.h. in einer Ebene spiralförmig, oder durch eine mehrlagige Ausgestaltung der Schichtanordnung als Helix, d.h. als räumlich oder schraubenförmig verlaufende Spirale, ausgestaltet ist.

Die Schichtanordnung kann auch als Übertrager oder Transformator ausgestaltet werden. Hierzu ist dann vorgesehen, dass zwischen der zweiten Isolierschicht, die also auf der Leiterschicht aufliegt, und der zweiten Magnetschicht, die die gesamte Schichtanordnung zur Umgebung hin abgrenzt, eine weitere Leiterschicht und eine weitere diese gegen die zweiten Magnetschicht elektrisch isolierende weitere Isolierschicht angeordnet ist. Es verlaufen in der Schichtanordnung dann also zwei Leiterschichten parallel zueinander, die untereinander durch die zweite Isolierschicht und gegenüber den beiden Magnetschichten durch die erste Isolierschicht und durch die dritte Isolierschicht elektrisch isoliert sind. Die beiden Leiterschichten sind durch die erste Magnetschicht und die zweite Magnetschicht damit induktiv gekoppelt.

Ein weiterer Vorteil ergibt sich, dadurch dass der Kühlkörper nicht nur als Trägerelement oder Versteifungselement und Kühlung für die Schichtanordnung allein, sondern auch zum Versteifen und/oder Kühlen einer größeren Schaltungsstruktur genutzt wird. Hierzu ist dann vorgesehen, dass auf der Oberfläche des Kühlkörpers zumindest ein schaltbares elektronisches Bauelement, zum Beispiel ein Transistor, angeordnet ist. Das Bauelement ist dann an einen der Anschlussbereiche elektrisch verbunden oder mit diesem verschaltet, sodass also die Schichtanordnung und das zumindest eine elektronische Bauelemente eine elektrische Gesamtschaltung ergeben.

Um das zumindest eine elektronische Bauelement von der Schichtanordnung, insbesondere der Schichtanordnung mit Magnetschicht, thermisch zu entkoppeln, ist vorgesehen, dass zwischen dem zumindest einen Bauelement einerseits und der Schichtanordnung andererseits die Oberfläche des Kühlkörpers zumindest zwei Materialaussparungen aufweist und zwischen jeweils zwei der Materialaussparungen sich ein Brückenelement ergibt, über welches die Schichtanordnung mit dem zumindest eine Bauelement elektrisch verbunden ist. Durch die Materialaussparungen ergibt sich ein Hohlraum oder ein Luftraum rechts und links neben jedem Brückenelement, so dass im Material des Kühlkörpers Verlustwärme nicht rechts und links an dem Brückenelement vorbei, sondern nur innerhalb des Brückenelements zwischen dem zumindest einen Bauelement einerseits und der Schichtanordnung andererseits diffundieren oder geleitet werden kann. Die Materialaussparungen stellen somit eine thermische Entkopplung dar.

Die erfindungsgemäße Schaltungsanordnung ist auf der Grundlage eines Kaltgas-Spritzverfahrens hergestellt. Mit anderen Worten sind die Schichten der Schichtanordnung, d.h. die Isolierschicht und die Leiterschicht und die weiteren beschriebenen Schichten, alle oder zumindest eine oder einige davon jeweils durch Kaltgasspritzen hergestellt. Dies bedeutet, dass ein Material der jeweiligen Schicht als Pulver oder Granulat aufgetragen ist und hierbei die Partikel des Pulvers oder Granulats ineinander verzahnt und/oder miteinander teilverschmolzen sind, also an Berührflächen miteinander verschmolzen sind. Das Material jeder Schicht bildet somit jeweils insbesondere eine poröse oder gekörnte Struktur.

Die Schaltungsanordnung mit der Schichtanordnung und dem zumindest einen Bauelement ist bevorzugt als Gleichspannungswandler oder als Wechselrichter ausgestaltet. Somit kann insbesondere in einem Kraftfahrzeug oder allgemeinen in einer vibrierenden Umgebung, wie sie beispielsweise beim Betrieb einer elektrischen Maschine verursacht werden kann, mittels der Schaltungsanordnung eine solche elektrische Maschine betrieben werden.

Um eine Kühlleistung, welche an der Schichtanordnung wirksam ist, zu vergrößern, ist bevorzugt vorgesehen, dass in oder an dem Kühlkörper ein Kühlkanal oder allgemein eine Kühlstruktur zum Führen eines Kühlmediums bereitgestellt ist. Somit kann der Kühlkörper beispielsweise mit Wasser oder Öl als Kühlmedium durchspült werden oder es kann Kühlluft geführt werden.

Das erfindungsgemäße Kraftfahrzeug sieht vor, dass eine elektrische Spannungsquelle, beispielsweise eine elektrische Batterie, insbesondere eine Traktionsbatterie, mit zumindest einem Hochstromverbraucher einer Ausführungsform der erfindungsgemäßen Schaltungsanordnung elektrisch verbunden ist. Als Hochstromverbraucher wird hier ein elektrischer Verbraucher angesehen, der einen Betriebsstrom größer als 10 A aufweist. Ein solcher Hochstromverbraucher kann beispielsweise eine elektrische Maschine sein, die beispielsweise zum Fahrbetrieb oder Fahrantrieb des Kraftfahrzeugs bereitgestellt sein kann. Beispielsweise kann auch eine Ausgleichsschaltung zum Ausgleich verschiedener Potentiale damit realisiert werden.

Zu der Erfindung gehören auch Weiterbildungen des erfindungsgemäßen Verfahrens, die Merkmale aufweisen, wie sie bereits im Zusammenhang mit den Weiterbildungen der erfindungsgemäßen Schaltungsanordnung beschrieben worden sind. Aus diesem Grund sind die entsprechenden Weiterbildungen des erfindungsgemäßen Verfahrens hier nicht noch einmal beschrieben.

Im Folgenden ist ein Ausführungsbeispiel der Erfindung beschrieben. Hierzu zeigt:
- Fig. 1: eine schematische Darstellung einer Ausführungsform des erfindungsgemäßen Kraftfahrzeugs;
- Fig. 2: eine schematische Darstellung einer perspektivischen Ansicht einer Ausführungsform der erfindungsgemäßen Schaltungsanordnung, die in dem Kraftfahrzeug von Fig. 1 bereitgestellt sein kann;
- Fig. 3: eine schematische Darstellung eines Querschnitts der Schaltungsanordnung von Fig. 2; und
- Fig. 4: eine Skizze zur Veranschaulichung möglicher Formen eines elektrischen Verbindungspfads, der durch die Schaltungsanordnung gebildet sein kann.

Bei dem im Folgenden erläuterten Ausführungsbeispiel handelt es sich um eine bevorzugte Ausführungsform der Erfindung. Bei dem Ausführungsbeispiel stellen die beschriebenen Komponenten der Ausführungsform jeweils einzelne, unabhängig voneinander zu betrachtende Merkmale der Erfindung dar, welche die Erfindung jeweils auch unabhängig voneinander weiterbilden und damit auch einzeln oder in einer anderen als der gezeigten Kombination als Bestandteil der Erfindung anzusehen sind. Des Weiteren ist die beschriebene Ausführungsform auch durch weitere der bereits beschriebenen Merkmale der Erfindung ergänzbar, solange die entsprechenden Kombinationen im Rahmen der Ansprüche liegen.

In den Figuren sind funktionsgleiche Elemente jeweils mit denselben Bezugszeichen versehen.

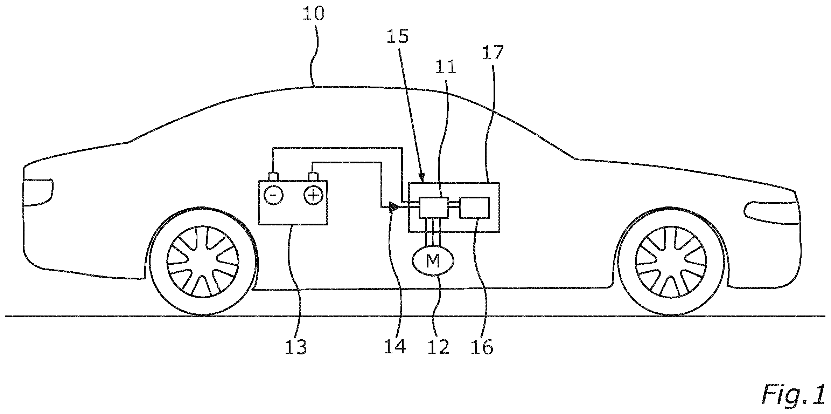

Fig. 1 zeigt ein Kraftfahrzeug 10, bei dem es sich beispielsweise um einen Kraftwagen, insbesondere einen Personenkraftwagen oder Lastkraftwagen, handeln kann. Das Kraftfahrzeug 10 kann einen Hochstromverbraucher 11 aufweisen, der in dem gezeigten Beispiel ein Inverter oder Wechselrichter einer elektrischen Maschine 12 sein kann. Mittels der elektrischen Maschine 12 kann beispielsweise ein Fahrantrieb für das Kraftfahrzeug 10 bereitgestellt sein. Zum Betreiben oder Versorgen des Hochstromverbrauchers 11 kann dieser mit einer Spannungsquelle 13 elektrisch verbunden sein, bei der es sich in dem gezeigten Beispiel um eine Batterie, beispielsweise eine Traktionsbatterie oder Hochvoltbatterie handeln kann. Ein Betriebsstrom 14 für den Hochstromverbraucher 11 kann größer als 10 A, insbesondere größer als 50 A, sein.

Zum Reduzieren einer Welligkeit eines zeitlichen Verlaufs des Betriebsstroms 14 und/oder für eine Gleichspannungswandlung kann in der Schaltungsanordnung 15 eine Induktivität 16 bereitgestellt sein. Die Schaltungsanordnung 15 weist einen Kühlkörper 17 auf, auf welchem gemeinsam die Induktivität 16 und der Hochstromverbraucher 11 angeordnet sind, d.h. elektronische Bauelemente des Hochstromverbrauchers 11 sind in die Schaltungsanordnung 15 integriert.

Die Induktivität 16 ist flach oder flächig verteilt und zusätzlich durch den Kühlkörper 17 versteift. Bei Vibrationen während einer Fahrt des Kraftfahrzeugs 10 kann somit die Induktivität 16 durch die Vibrationen nicht zu einer Eigenschwingung angeregt oder aufgeschaukelten werden. Zudem ist eine gleichmäßige Kühlung, d.h. eine Vermeidung von Hotspots, gewährleistet.

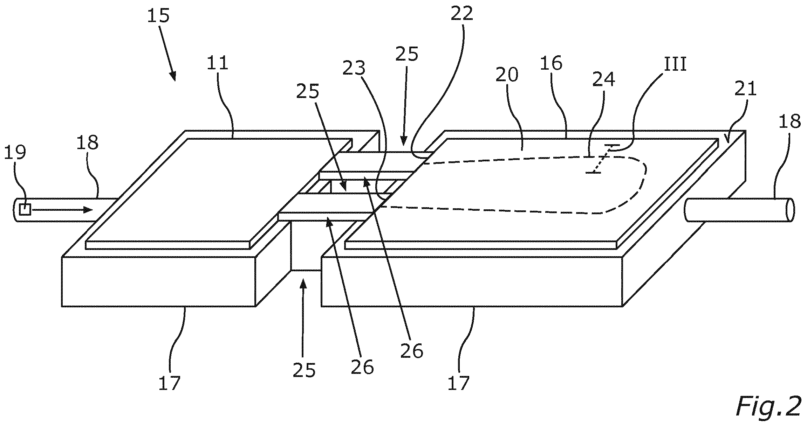

Fig. 2 veranschaulicht die flächige oder flache Ausgestaltung der Induktivität 16. Fig. 2 zeigt den Kühlkörper 17, der beispielsweise ein Spritzgussbauteil sein kann. Ein Material des Kühlkörpers 17 kann beispielsweise Aluminium oder eine Aluminiumlegierung umfassen. Mittels einer Kühlstruktur 18 kann ein Kühlmedium 19 zum Abtransportieren oder Ableiten von Wärmeenergie aus dem Kühlkörper 17 durch diesen hindurch oder an diesem vorbei geleitet oder geführt oder geströmt werden. Die Kühlstruktur kann z.B. einen Kühlkanal und/oder Kühlrippen vorsehen.

Die Induktivität 16 ist durch eine Schichtanordnung 20 gebildet, die auf einer Oberfläche 21 des Kühlkörpers 17 angeordnet sein kann. Die Schichtanordnung 20 weist eine elektrisch leitfähigen Teil auf, sodass ein erster Anschlussbereich 22 und ein zweiter Anschlussbereich 23 über die Schichtanordnung 20 elektrisch verbunden sind und sich hierdurch für den Betriebsstroms 14 ein elektrischer Verbindungspfad 24 zwischen den Anschlussbereichen 22, 23 ergibt.

Die Schichtanordnung 20 ist thermisch mit dem Hochstromverbraucher 11 trotz des gemeinsamen Kühlkörpers 17 nur geringfügig gekoppelt. Der Kühlkörper 17 weist hierzu an seiner Oberfläche 21 Materialaussparungen 25 auf, die beispielsweise beim Herstellen des Kühlkörpers 17 durch eine entsprechende Gussform und/oder durch Ausfräsen oder Ausbohren hergestellt sein können. Durch den jeweils verbleibenden Teil des Kühlkörpers 17 zwischen jeweils zwei der Materialaussparungen 25 ist ein Brückenelement 26 gebildet, über welches die Schichtanordnung 20 mit dem Hochstromverbraucher 11 elektrisch verbunden sein kann.

Entlang des Verbindungspfads 24 ist durch die Schichtanordnung 20 und den Kühlkörper 17 ist die Induktivität 16 bereitgestellt. Es können auch mehrere, elektrisch getrennte Verbindungspfade 24 und mehrere Induktivitäten 16 durch die Schichtanordnung 20 bereitgestellt sein, was durch entsprechend vielfache Bereitstellung der folgenden Strukturen möglich ist.

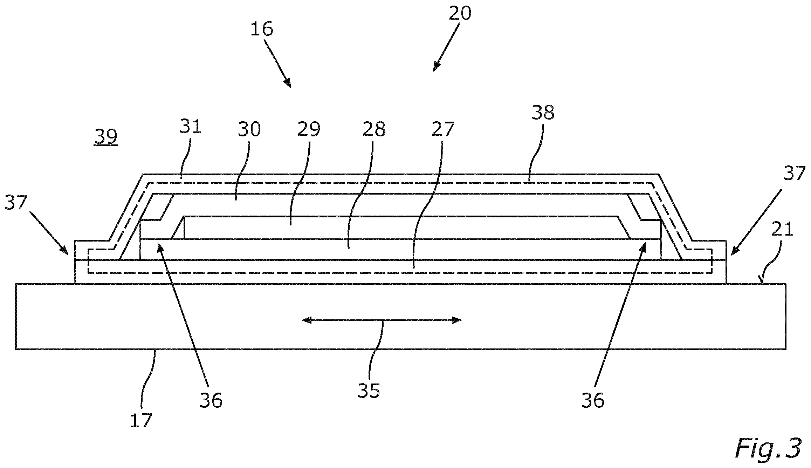

Fig. 3 veranschaulicht einen Querschnitt senkrecht zur Verlauf des Verbindungspfads 24. Die Schnittlinie für den Schnitt gemäß Fig. 3 ist in Fig. 2 als III bezeichnet.

Ausgehend von dem Kühlkörper 17 ist auf dessen Oberfläche 21 in dem veranschaulichten Beispiel eine erste Magnetschicht 27, eine erste Isolierschicht 28, eine Leiterschicht 29, eine zweite Isolierschicht 30 und eine zweite Magnetschicht 31 in dieser Reihenfolge angeordnet. Die Schichten 27, 28, 29, 30, 31 Stellen zusammen die Schichtanordnung 20 dar. Die Schichtanordnung 20 wird in einem Beschichtungsverfahren auf die Oberfläche 21 des Kühlkörpers 17 aufgebracht. Dabei wird mindestens eine der Schichten durch Kaltgasspritzen aufgebracht.

Durch die Schichtanordnung 20 mit den Magnetschichten 27, 31 kann der elektrische Verbindungspfad 24 auf den Betriebsstrom 14 als die Induktivität 16 wirken, d.h. wie eine elektrische Spule oder eine Drossel wirken, die einen vorgegebenen Induktivitätswert aufweist.

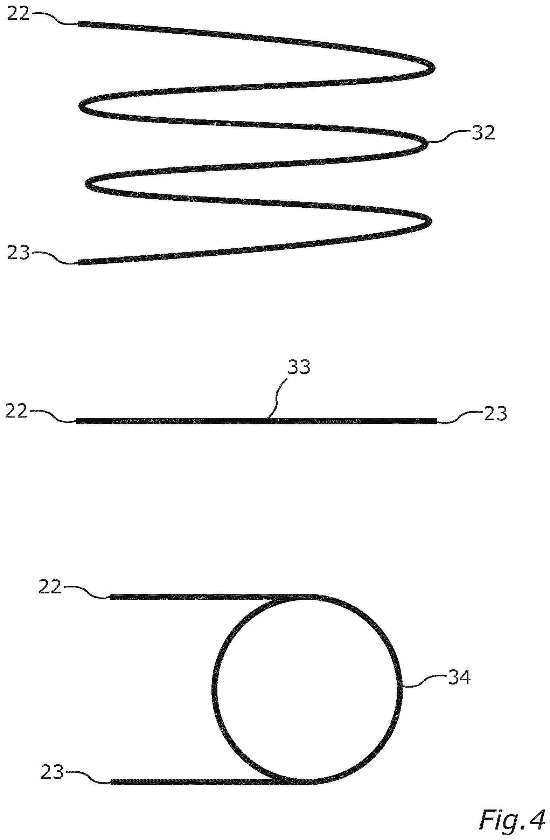

Fig. 4 zeigt beispielhaft mögliche Formen des Verbindungspfads 24, nämlich eine Mäanderform 32, einen geraden Leiter 33 und eine Draufsicht auf eine sich dreidimensionale windende Form, d.h. eine Helix 34. Die Helix 34 muss hierbei als mehrfache Wiederholung oder als Stapelung der Schichtanordnung 20 erzeugt werden. Die Form beeinflusst den Induktivitätswert.

Die Induktivität 16 wird durch das besagte Beschichtungsverfahren aufgebracht und geformt. Dazu wird auf dem Kühlkörper 17 d.h. dessen Oberfläche aus Aluminium oder einem anderen Metall, die Magnetschicht 27 aus einem magnetisch hochpermeablen Material, das heißt einem weichmagnetischen Material, aufgetragen. Zum Einstellen des Induktivitätswerts kann eine Form der Magnetschicht 27 mittels einer Schablone oder Maske festgelegt werden. Mit anderen Worten bildet die Magnetschicht 27 einen auf der Oberfläche 21 angeordneten Streifen oder ein Band.

Auf die Magnetschicht 27 wird eine elektrisch isolierende Isolierschicht 28 aufgetragen, die beispielsweise auf der Grundlage einer Keramik oder Aluminiumoxid als Material für die elektrische Isolierung bereitgestellt werden kann. Die Isolierschicht 28 überdeckt in einer Querrichtung 35 quer zur Verlaufsrichtung des Verbindungspfades 24 die Magnetschicht 27 an den Rändern nicht vollständig, sondern nur teilweise. Auf die Isolierschicht 27 wird eine elektrisch leitfähige Leiterschicht 29 aufgetragen, die den Betriebsstrom 14 als Dauerstrom tragen kann und die Spitzenströme bis zu einem vorgegebenen Stromwert bei entsprechendem Wärmeübergang und der Kühlung im Kühlkörper 17 unbeschädigt überstehen kann. Die Leiterschicht 29 deckt in Querrichtung 25 die Isolierschicht 28 ebenfalls nur teilweise ab, sodass an den Rändern eine Stufe gebildet ist.

Auf die Leiterschicht 29 kommt eine weitere elektrisch isolierende zweite Isolierschicht 30, welche die beiden darunterliegenden Schichten, d.h. die Leiterschicht 29 und die erste Isolierschicht 28 vollständig überdeckt, sodass sich eine Verbindung 36 zwischen den beiden Isolierschicht 28, 30 ergibt. Hierdurch ist die Leiterschicht 29 vollständig von elektrisch isolierendem Material in dem Querschnitt umgeben. Hierdurch ist eine galvanische Trennung zu den Magnetschichten 27 und 31 gewährleistet. Des Weiteren können Kriechstrecken hin zur Oberfläche 21 und zur Magnetschicht 27 kürzer ausgelegt sein als mit einer ausschließlich durch Luft gebildeten Beabstandung. Nach außen hin abgeschlossen oder abgegrenzt wird die Schichtanordnung 20 durch eine weitere magnetisch hochpermeable Magnetschicht 31, die mit der untersten Magnetschicht 27 durch Überdeckung 37 verbunden ist. Somit bilden die beiden Magnetschichten 27, 31 einen geschlossenen Magnetkreis 38, welcher im Querschnitt die Leiterschicht 29 einschließt oder umringt. Somit ist durch die Schichtanordnung 20 eine flächige oder flache Induktivität bereitgestellt, die durch die flache Form mittels des Kühlkörpers 17 gekühlt werden kann.

Das Auftragen des jeweiligen Materials der Schichten 27, 28, 29, 30, 31 wird mittels eines Kaltgasverfahrens durchgeführt. Hierbei wird die Schichtanordnung 20 auf dem gleichen Kühlkörper 17 zusammen mit elektrischen Bauelementen, beispielsweise Leistungsschaltern oder Transistoren des Hochstromverbrauchers 11 angeordnet. Durch Bereitstellen einer weiteren Leiterschicht in der Schichtanordnung 20 (nicht dargestellt) kann auch ein Transformator hergestellt werden. Es ergibt sich eine gleichmäßige flächige thermische Anbindung der Induktivität 16 an den Kühlkörper 17. Durch den geschlossenen Magnetkreis 38 sind Streufelder in der Umgebung 39 der Schichtanordnung 20 reduziert. Somit ist die elektromagnetische Verträglichkeit (EMV) verbessert.

Durch eine sich mittels des Kaltgasspritzens einstellbare poröse oder körnige Struktur der Magnetschichten 27, 31 ist kein dedizierter oder lokal konzentrierter Luftspalt zum Einstellen der Induktivität 16 nötig. Zudem ist eine Kühlung oder Wärmeabfuhr möglich, so dass insbesondere Temperaturen der Leiterschicht 29 oberhalb eines Maximalwerts vermieden sind. Durch das Anordnen des Hochstromverbrauchers 11 und der Induktivität 16 auf derselben Oberfläche 21 ist auch eine elektrische Anbindung über die Brückenelemente 26 mit einem Abstand kleiner als 10 cm möglich, ohne dass es hierbei zu einer unerwünschten thermischen Kopplung kommt. Anstelle eines Inverters kann auch als Hochstromverbraucher 11 zum Beispiel ein DC-DC-Wandler oder Gleichspannungswandler vorgesehen sein. Die Induktivität 16 kann für einen Buck-Konverter oder Boost-Konverter vorgesehen sein oder als Filter zum Reduzieren einer Welligkeit eines zeitlichen Verlaufs einer Stromstärke.

Insgesamt zeigt das Beispiel, wie durch die Erfindung eine geschichtete Induktivität bereitgestellt werden kann.

### Bezugszeichenliste

- 10: Kraftfahrzeug
- 11: Hochstromverbraucher
- 12: Elektrische Maschine
- 13: Spannungsquelle
- 14: Betriebsstrom
- 15: Schaltungsanordnung
- 16: Schmelzsicherung
- 17: Kühlkörper
- 18: Kühlkanal
- 19: Kühlmedium
- 20: Schichtanordnung
- 21: Oberfläche
- 22: Anschlussbereich
- 23: Anschlussbereich
- 24: Verbindungspfad
- 25: Materialaussparung
- 26: Brückenelement
- 27: Erste Magnetschicht
- 28: Erste Isolierschicht
- 29: Leiterschicht
- 30: Zweite Isolierschicht
- 31: Zweite Magnetschicht
- 32: Meanderform
- 33: Gerade Linie
- 34: Helix
- 35: Querrrichtung
- 36: Verbindung
- 37: Überlappung
- 38: Magnetischer Kreis
- 39: Umgebung

## Patentansprüche

1. Schaltungsanordnung (15), aufweisend:
- einen Kühlkörper (17) und
- eine auf einer Oberfläche (21) des Kühlkörpers (17) angeordnete Schichtanordnung (20), die eine erste elektrisch isolierende Isolierschicht (28) und eine auf einer dem Kühlkörper (17) abgewandten Seite der Isolierschicht (28) angeordnete elektrisch leitfähige Leiterschicht (29) aufweist, wobei durch die Schichtanordnung (20) ein elektrischer Verbindungspfad (24) zwischen zwei elektrischen Anschlussbereichen (22, 23) bereitgestellt ist,
- wobei die Schichtanordnung durch Kaltgasspritzen eines jeweiligen Materials einer oder einiger oder jeder der Schichten (28, 29) der Schichtanordnung (20) gebildet ist,
- wobei die Schaltungsanordnung (15) ferner einen Hochstromverbraucher (11) aufweist, der auf der Oberfläche (21) des Kühlkörpers (17) angeordnet ist und der einen Betriebsstrom größer als 10 A aufweist,
- **dadurch gekennzeichnet, dass** der Kühlkörper (17) an der Oberfläche (21) und zwischen dem Hochstromverbraucher (11) einerseits und der Schichtanordnung (20) andererseits mindestens zwei Materialaussparungen (25) zur thermischen Entkopplung aufweist.

2. Schaltungsanordnung (15) nach Anspruch 1, wobei die Schaltungsanordnung (15) zwischen jeweils zwei der Materialaussparungen (25) ein Brückenelement (26) aufweist, über welches die Schichtanordnung (20) mit dem Hochstromverbraucher (11) elektrisch verbunden ist.

3. Schaltungsanordnung (15) nach Anspruch 1 oder 2, wobei zum Einstellen eines elektrischen Induktivitätswerts des Verbindungspfads (24) die Schichtanordnung (20) eine zwischen der Oberfläche (21) des Kühlkörpers (17) und der ersten Isolierschicht (28) angeordnete Magnetschicht (27) aus einem weichmagnetischen Material und eine an einer der ersten Isolierschicht (28) abgewandten Seite der Leiterschicht (29) angeordnete zweite Isolierschicht (30) sowie eine zweite Marmetschicht (31) aufweist, wobei die Leiterschicht (29) zwischen der ersten Magnetschicht (27) und der zweiten Magnetschicht (31) angeordnet ist.

4. Schaltungsanordnung (15) nach Anspruch 3, wobei die zweite Magnetschicht (31) entlang eines Verlaufes des elektrischen Verbindungspfads (24) beiderseits des Verbindungspfads (24) mit der ersten Magnetschicht (27) verbunden (37) ist oder
wobei die beiden Magnetschichten (27, 31) durch zumindest eine der Isolierschichten (28, 30) elektrisch gegeneinander isoliert sind.

5. Schaltungsanordnung (15) nach Anspruch 3 oder 4, wobei zwischen dem Kühlkörper (17) und der ersten Magnetschicht eine weitere Isolierschicht angeordnet ist.

6. Schaltungsanordnung (15) nach einem der Ansprüche 3 bis 5, wobei das weichmagnetische Material der ersten Magnetschicht (27) und/oder der zweiten Magnetschicht (31) porös ist.

7. Schaltungsanordnung (15) nach einem der Ansprüche 3 bis 6, wobei die Schichtanordnung (20) zwischen der zweiten Isolierschicht (30) und der zweiten Magnetschicht (31) eine weitere Leiterschicht und eine diese von der zweiten Magnetschicht (31) isolierende dritte Isolierschicht aufweist und die beiden Leiterschichten (29) durch die erste Magnetschicht (27) und die zweite Magnetschicht (31) induktiv gekoppelt sind.

8. Schaltungsanordnung (15) nach einem der Ansprüche 3 bis 7, wobei die zweite Isolierschicht (30) entlang des Verlaufes des elektrischen Verbindungspfads (24) beiderseits des Verbindungspfads (24) mit der ersten Isolierschicht (28) verbunden (36) ist.

9. Schaltungsanordnung (15) nach einem der vorhergehenden Ansprüche, wobei der Verbindungspfad (24) meanderförmig (32) oder als Flachspule oder durch eine mehrlagige Ausgestaltung der Schichtanordnung (20) als Helix (34) ausgestaltet ist.

10. Schaltungsanordnung (15) nach einem der vorhergehenden Ansprüche, wobei der Hochstromverbraucher (11) als Gleichspannungswandler oder als Wechselrichter ausgestaltet ist.

11. Schaltungsanordnung (15) nach einem der vorhergehenden Ansprüche, wobei in oder an dem Kühlkörper (17) eine Kühlstruktur (18) zum Führen eines Kühlmediums (19) bereitgestellt ist.

12. Kraftfahrzeug (10) mit einer elektrischen Spannungsquelle (13), wobei die Spannungsquelle (13) und eine Schaltungsanordnung (15) nach einem der vorhergehenden Ansprüche elektrisch miteinander verbunden sind.

13. Verfahren zum Herstellen einer Schaltungsanordnung (15) nach einem der Ansprüche 1 bis 11, wobei auf der Oberfläche (21) des Kühlkörpers (17) mittels Kaltgasspritzens die Schichtanordnung (20) aus der Isolierschicht (28) aus einem elektrisch isolierenden Material und der auf der dem Kühlkörper (17) abgewandten Seite der Isolierschicht (28) angeordneten Leiterschicht (29) aus einem elektrisch leitfähigen Material erzeugt wird, wobei durch die Schichtanordnung (20) der elektrische Verbindungspfad (24) zwischen den zwei Anschlussbereichen (22, 23) bereitgestellt wird.

## Claims

1. Circuit arrangement (15), having:
- a heat sink (17) and
- a layer arrangement (20), which is arranged on a surface (21) of the heat sink (17) and which has a first electrically insulating insulation layer (28) and an electrically conductive conductor layer (29) arranged on a side of the insulation layer (28) facing away from the heat sink (17), wherein an electrical connecting path (24) between two electrical connection regions (22, 23) is provided by the layer arrangement (20),
- wherein the layer arrangement is formed by cold gas spraying of a respective material of one or some or each of the layers (28, 29) of the layer arrangement (20),
- wherein the circuit arrangement (15) also has a high-current load (11), which is arranged on the surface (21) of the heat sink (17) and which has an operating current greater than 10 A,
- **characterized in that**, on the surface (21) and between the high-current load (11) on the one hand and the layer arrangement (20) on the other hand, the heat sink (17) has at least two material cutouts (25) for thermal decoupling.

2. Circuit arrangement (15) according to Claim 1, wherein the circuit arrangement (15) has a bridge element (26) between in each case two of the material cutouts (25), by means of which bridge element the layer arrangement (20) is electrically connected to the high-current load (11).

3. Circuit arrangement (15) according to Claim 1 or 2, wherein, in order to set an electrical inductance value of the connecting path (24), the layer arrangement (20) has a magnetic layer (27), which is composed of a soft-magnetic material and arranged between the surface (21) of the heat sink (17) and the first insulation layer (28), and a second insulation layer (30) arranged on a side of the conductor layer (29) facing away from the first insulation layer (28), and also a second magnetic layer (31), wherein the conductor layer (29) is arranged between the first magnetic layer (27) and the second magnetic layer (31).

4. Circuit arrangement (15) according to Claim 3, wherein the second magnetic layer (31) is connected (37) to the first magnetic layer (27) along a profile of the electrical connecting path (24) on both sides of the connecting path (24) or
wherein the two magnetic layers (27, 31) are electrically insulated from one another by at least one of the insulation layers (28, 30).

5. Circuit arrangement (15) according to Claim 3 or 4, wherein a further insulation layer is arranged between the heat sink (17) and the first magnetic layer.

6. Circuit arrangement (15) according to one of Claims 3 to 5, wherein the soft-magnetic material of the first magnetic layer (27) and/or of the second magnetic layer (31) is porous.

7. Circuit arrangement (15) according to one of Claims 3 to 6, wherein the layer arrangement (20) has between the second insulation layer (30) and the second magnetic layer (31) a further conductor layer and a third insulation layer insulating said further conductor layer from the second magnetic layer (31) and the two conductor layers (29) are inductively coupled by the first magnetic layer (27) and the second magnetic layer (31).

8. Circuit arrangement (15) according to one of Claims 3 to 7, wherein the second insulation layer (30) is connected (36) to the first insulation layer (28) along the profile of the electrical connecting path (24) on both sides of the connecting path (24).

9. Circuit arrangement (15) according to one of the preceding claims, wherein the connecting path (24) is designed in a meander-shaped manner (32) or as a flat coil or, owing to a multilayer design of the layer arrangement (20), as a helix (34).

10. Circuit arrangement (15) according to one of the preceding claims, wherein the high-current load (11) is designed as a DC voltage converter or as an inverter.

11. Circuit arrangement (15) according to one of the preceding claims, wherein a cooling structure (18) is provided in or on the heat sink (17) in order to guide a cooling medium (19).

12. Motor vehicle (10) having an electrical voltage source (13), wherein the voltage source (13) and a circuit arrangement (15) according to one of the preceding claims are electrically connected to one another.

13. Method for producing a circuit arrangement (15) according to one of Claims 1 to 11, wherein the layer arrangement (20) composed of the insulation layer (28) made of an electrically insulating material and the conductor layer (29) made of an electrically conductive material arranged on the side of the insulation layer (28) facing away from the heat sink (17) is produced on the surface (21) of the heat sink (17) by means of cold gas spraying, wherein the electrical connecting path (24) between the two connection regions (22, 23) is provided by the layer arrangement (20).

## Revendications

1. Arrangement de circuit (15), comprenant :
- un dissipateur de chaleur (17) et
- un arrangement de couches (20) disposé sur une surface (21) du dissipateur de chaleur (17), lequel possède une première couche isolante (28) électriquement isolante et une couche conductrice (29) électriquement conductrice disposée sur le côté de la couche isolante (28) à l'opposé du dissipateur de chaleur (17), un chemin de liaison (24) électrique entre deux zones de raccordement électriques (22, 23) étant fourni par l'arrangement de couches (20),
- l'arrangement de couches étant formé par projection de gaz à froid d'un matériau respectif d'une ou de quelques-unes ou de chacune des couches (28, 29) de l'arrangement de couches (20),
- l'arrangement de circuit (15) possédant en outre un consommateur à courant fort (11) qui est disposé sur la surface (21) du dissipateur de chaleur (17) et qui présente un courant de service supérieur à 10 A,
- **caractérisé en ce que** le dissipateur de chaleur (17) possède, sur la surface (21) et entre le consommateur à courant fort (11) d'un côté et l'arrangement de couches (20) de l'autre côté, au moins deux creux de matière (25) servant au découplage thermique.

2. Arrangement de circuit (15) selon la revendication 1, l'arrangement de circuit (15) possédant respectivement entre deux creux de matière (25) un élément formant pont (26), par le biais duquel l'arrangement de couches (20) est relié électriquement au consommateur à courant fort (11).

3. Arrangement de circuit (15) selon la revendication 1 ou 2, l'arrangement de couches (20) possédant, en vue de régler une valeur d'inductance électrique du chemin de liaison (24), une couche magnétique (27) en un matériau magnétique doux entre la surface (21) du dissipateur de chaleur (17) et la première couche isolante (28) et une deuxième couche isolante (30) disposée sur un côté de la couche conductrice (29) à l'opposé de la première couche isolante (28) ainsi qu'une deuxième couche magnétique (31), la couche conductrice (29) étant disposée entre la première couche magnétique (27) et la deuxième couche magnétique (31).

4. Arrangement de circuit (15) selon la revendication 3, la deuxième couche magnétique (31) étant reliée (37) à la première couche magnétique (27) des deux côtés du chemin de liaison (24) le long d'un tracé du chemin de liaison (24) électrique ou les deux couches magnétiques (27, 31) étant isolées électriquement l'une de l'autre par au moins l'une des couches isolantes (28, 30) .

5. Arrangement de circuit (15) selon la revendication 3 ou 4, une couche isolante supplémentaire étant disposée entre le dissipateur de chaleur (17) et la première couche magnétique.

6. Arrangement de circuit (15) selon l'une des revendications 3 à 5, le matériau magnétique doux de la première couche magnétique (27) et/ou de la deuxième couche magnétique (31) étant poreux.

7. Arrangement de circuit (15) selon l'une des revendications 3 à 6, l'arrangement de couches (20) possédant une couche conductrice supplémentaire entre la deuxième couche isolante (30) et la deuxième couche magnétique (31) et une troisième couche isolante isolant celle-ci de la deuxième couche magnétique (31) et les deux couches conductrices (29) étant couplées inductivement par la première couche magnétique (27) et la deuxième couche magnétique (31).

8. Arrangement de circuit (15) selon l'une des revendications 3 à 7, la deuxième couche isolante (30) étant reliée (36) à la première couche isolante (28) des deux côtés du chemin de liaison (24) le long d'un tracé du chemin de liaison (24) électrique.

9. Arrangement de circuit (15) selon l'une des revendications précédentes, le chemin de liaison (24) étant réalisé en forme de méandre (32) ou sous la forme d'une bobine plate ou par une configuration multicouche de l'arrangement de couches (20) sous la forme d'une hélice (34).

10. Arrangement de circuit (15) selon l'une des revendications précédentes, le consommateur à courant fort (11) étant réalisé sous la forme d'un convertisseur de tension continue ou sous la forme d'un onduleur.

11. Arrangement de circuit (15) selon l'une des revendications précédentes, une structure de refroidissement (18) servant au guidage d'un fluide de refroidissement (19) étant fournie dans ou sur le dissipateur de chaleur (17).

12. Véhicule automobile (10) comprenant une source de tension (13) électrique, la source de tension (13) et un arrangement de circuit (15) selon l'une des revendications précédentes étant reliés électriquement l'un à l'autre.

13. Procédé de fabrication d'un arrangement de circuit (15) selon l'une des revendications 1 à 11, l'arrangement de couches (20), constitué de la couche isolante (28) en un matériau électriquement isolant et de la couche conductrice (29) en un matériau électriquement conducteur disposée sur le côté de la couche isolante (28) à l'opposé du dissipateur de chaleur (17), étant généré sur la surface (21) du dissipateur de chaleur (17) au moyen de la projection de gaz à froid, le chemin de liaison (24) électrique entre les deux zones de raccordement (22, 23) étant fourni par l'arrangement de couches (20).
